# EUROPEAN PATENT APPLICATION

(11) **EP 0 936 045 A1**
(43) Date of publication of application: **18.08.1999**
(21) Application number: 99301036.2
(22) Date of filing: 12.02.1999
(51) Int. Cl.: B29C 45/14, H05K 9/00

(54) **Molded electromagnetic shielding housings**

(30) Priority: 12.02.1998 US 22742
(71) Applicant: NATIONAL-STANDARD COMPANY, Niles Michigan 49120 (US)
(72) Inventor: Burton, Paul, Grand Rapids, Michigan 49508 (US)
(74) Representative: Manaton, Ross Timothy

(57) **Abstract**

An apparatus and method for molding electromagnetic shielding housings is disclosed. The molding apparatus (12) includes a core portion (14), a cavity portion (16) and an injection opening (17). Positioning means is provided to retain a conductive flexible metal grid material (26) on the surface of either the core or the cavity portion. Upon injection of moldable plastic through the injection opening (17), the resultant molded shielding housing has the conductive metal grid material molded integrally with the plastic molding.

## Description

This invention relates to molded electromagnetic shielding housings for shielding electromagnetic waves entering and emitting from electronic devices.

Electromagnetic interference (E.M.I.) shielding structures or housings have been developed to provide protection for electronic instruments or devices from electromagnetic energy, including radio frequency interference (R.F.I.). The shielding structures or housings are intended to provide protection for the electronic device by preventing electromagnetic wave energy from penetrating the device, as well as from escaping from the device.

Such electromagnetic shielding housings have been generally made by the formation of sheet metal boxes, conductive paints applied to a plastic housing, die cast parts to construct a housing and filled resins containing metal fibers. However, the assembly of die-cast parts or panels to provide sheet metal box assemblies for providing electromagnetic shielding have found only limited acceptance because of the difficulties of weight restrictions in such shielding housings, the inability to make round shapes, noise problems associates with rattling of shielding components and the requirement of multiple parts to assemble the box-like housing. Conductive paints have been used for providing electromagnetic shielding, for example by electroplating metal onto a plastic, a process which requires multiple processing steps, provides poor performance, is cost prohibitive, presents environmental problems and is susceptible to chipping and flaking. Utilizing die cast or plate material shielding housing structures to enclose and shield electronic devices requires external connections at the joints of the plate materials or corners of the enclosure to provide a satisfactory box-like enclosure. Such assembly techniques are expensive and time consuming and often result in a structure which does not properly shield the enclosed device. Finally, filled resins containing metal fibers are very expensive and cause excessive wear in insert molding tooling and exhibit poor shielding properties. Accordingly, such shielding housings and methods of making have found only limited acceptance in the marketplace.

Although some prior art shielding structures have included a wire mesh or screen embedded within a molded product, the insertion of a mesh or screen into a mold cavity is a difficult process and results in fraying of the exposed mesh or screen, properties which detract from an acceptable molded shielding product. Moreover, such prior art molded shielding structures or housings do not possess sufficient corrosion resistance to provide a commercially acceptable shielding material. Also, such molded structures are substantially limited to only planar molding, that is, the mesh or screen may not be inserted into a mold cavity having corners and sidewalls. Accordingly, such shielding structures require complex contact junctions and joints between the panels during fabrication of box-like shielding structures, assembly techniques that are expensive and time consuming and which often result in unacceptable shielding structures.

The invention seeks to provide an improved electromagnetic shielding housing, and an apparatus and method for manufacturing the same. In one aspect, the invention provides apparatus for molding an electromagnetic shielding housing, the apparatus comprising; a core portion, a cavity portion, the core portion and cavity portion being moveable with respect to each other between an open position and a closed position for molding, an injection opening in at least one of said core portion or said cavity portion, and positioning means associated with at least one of said core portion or said cavity portion, the positioning means being adapted, in operation, to retain a conductive flexible metal grid material on at least one surface of the core portion, whereby, by injecting a moldable plastics material through said injection opening and subsequently hardening said plastics material, a completed molded shielding housing member may be produced, having said conductive metal grid material integrally positioned on at least one inside surface thereof.

In another aspect, the invention provides a method of molding an electromagnetic shielding housing in an injection molding machine having a core portion and a cavity portion, comprising the steps of positioning and retaining a conductive flexible metal grid material on at least one surface of either the core or the cavity portion, closing the core portion and the cavity portion together to confine the flexible metal grid material therebetween, directing injectable plastics material into the space between the core portion and the cavity portion, and opening the injection molding machine to remove the molded electromagnetic shielding housing having at least one surface thereof comprised of a conductive grid material molded integrally with the injectable plastics material.

Alternatively, the invention provides a molded box-like shielding housing or structure which contains a conductive flexible grid material which is non-reactive and noncorrosive with respect to the molded plastic.

In a further alternative, the invention provides a molded shielding housing structure containing a unitary conductive grid material, preferably comprised of a nickel-coated wire filament, molded therein.

The invention permits the manufacture of elements which can readily be assembled into a box-like shielding housing enclosing an electronic device. In preferred embodiments the housing is produced from a one-piece molding.

The novel grid shielding housing or structure in accordance with the present invention is obtained by molding the housing in an injection mold. The injection molding operation requires the predetermined placement and retention of a conductive grid material or substrate within the injection mold. The placement and retention of the grid material within the mold is obtained by magnetic or other positioning means associated with the mold cavity to fixedly position the conductive grid material upon a surface of the mold. The subsequently molded housing provides a shielding housing particularly useful in preventing electromagnetic waves from entering or escaping from an enclosed shielded electronic device.

During the molding operation, the conductive grid material is predeterminedly positioned upon a surface of the mold. Upon closure of the mold, the grid material is retained and positioned on the interior mold surface. The injection of the heated injectable plastic into the mold ensures that the grid material is positioned on and fixed to a surface of the molded housing. The positioning of the grid material on or adjacent the surface of the molded housing provides an excellent contact for shielding purposes. Also, the predetermined location and placement of the grid material on the surface of the mold core facilities plastic flow of the plastic into the mold, reduces and eliminates the knit lines occurring during the molding operation, reduces the impact of sink marks in the resultant molded structure and results in a molded structure wherein the grid substrate is integrally secured to the molded housing, properties which enhance the acceptability of the novel shielding structures in accordance with the present invention.

Additionally, when the grid material is sized larger than the mold cavity to extend outwardly from the edges of the mold, upon injection molding of the housing, the grid material provides an exposed conductive edge or ends for the molded housing after completion of the molding operation. The exposed conductive ends of the molded grid material provide an excellent contact and provide a seal at the corners of the molding which facilitates and aids in the assembly of box-like molded housings which constitute the shielding enclosure for the desired electronic device. Thus, if a panel has exposed conductive edge or ends and the panel is folded over to contact a complementary mating panel surface having exposed conductive edge or ends, the two panels interlock together and provide a conductive seal. thus, a conductive seal at the corner or edges of the molded housing is achieved by the wedging together of the grid materials exposed ends on the molded housing or panels. Additionally, the resultant structural positioning of the grid material extending through molding junctions between parts or surfaces of the molding, provides a reinforced hinge between the molded parts or surfaces of the one-piece housing. The hinged structure or junction permits the assembly of one-piece moldings into a box-like molded housing. Importantly, the exposed ends of the grid material do not fray during molding, handling or assembly of the box-like housing, thus preventing damage to the mold as well as facilitating the closure, sealing and interlocking of the molding parts during assembly of shielding housings.

A mesh-like grid material or structure useful in incorporation within a mold to provide the molded housing for shielding electromagnetic waves entering and exiting from various type electronic devices is available from National-Standard Company under the designation BOLTING cloth. Such mesh-like grid material or substrate is a nickel-coated filament material which is compatible with the molded plastic because the nickel-coated grid material does not oxidize when integrally molded to or adjacent the surface of the molded housing. Also, the nickel interstitices in the wire grid material are bonded together, a structure which permits the resultant grid material to exhibit substantial flexibility, strength, and high conductivity, for ready insertion and positioning within the mold cavity prior to the molding operation, properties which facilitate and aid the closure and sealing of box-like molded housings. Accordingly, the novel grid material or substrate may be advantageously positioned and inserted into an injection mold to provide a molded shielding housing or structure possessing excellent electromagnetic wave and radio frequency shielding properties.

The invention will hereinafter be described in more detail, by way of example only, and with reference to the accompanying drawings, in which:-
FIG. 1 is an enlarged schematic view illustrating the placement and retention of the conductive grid material within an injection mold in accordance with the present invention;
FIG. 2 is an enlarged schematic view illustrating the placement and retention of the conductive grid material within an injection mold in accordance with the present invention;
FIG. 3 is an enlarged schematic view illustrating the removal of the molded shielding housing from the mold with the integral positioning of the conductive grid material on the surface of the molded housing in accordance with the present invention;
FIG. 4 is a schematic view illustrating the placement and retention of the conductive grid material within an injection mold designed to produce a one-piece box-like shielding housing in accordance with the present invention;
FIG. 5 is a cross-sectional view of the one-piece box-like shielding housing molded in the apparatus of FIG. 4 in accordance with the present invention;
FIG. 5A is an enlarged view of the junction between molded panels of the molding depicted as 5A in FIG. 5;
FIG. 6 is an enlarged cross-sectional view illustrating the partial closure of the lid portion of the box-like shielding housing molded in accordance with the present invention;
FIG. 6A is an enlarged view of the hinged junction between molded panels of the molding depicted as 6A in FIG. 6;
FIG. 7 is an enlarged cross-sectional view illustrating the further closure of the lid portion of the box-like shielding housing molded in accordance with the present invention;
FIG. 7A is an enlarged view of the hinged junction between molded panels of the molding depicted as 7A in FIG. 7;
FIG. 8 is an enlarged cross-sectional view of the assembled box-like shielding housing made in accordance with the present invention;
FIG. 8A is an enlarged view of the hinged junction between molded panels of the box-like shielding housing depicted as 8A in FIG. 8;
FIG. 8B is an enlarged vie of the sealing engagement and closure between molded panels of the box-like shielding housing depicted as 8B in FIG. 8;
FIG. 9 is an enlarged top plan view taken along lines 9-9 in FIG. 8 showing the grid structure covering an opening within the molded housing to provide venting for the box-like shielding housing in accordance with the present invention; and
FIG. 10 is a perspective view illustrating a molded box-like shielding housing containing an electronic device which surrounds and prevents electromagnetic waves from penetrating or emitting from the electronic device in accordance with the present invention.

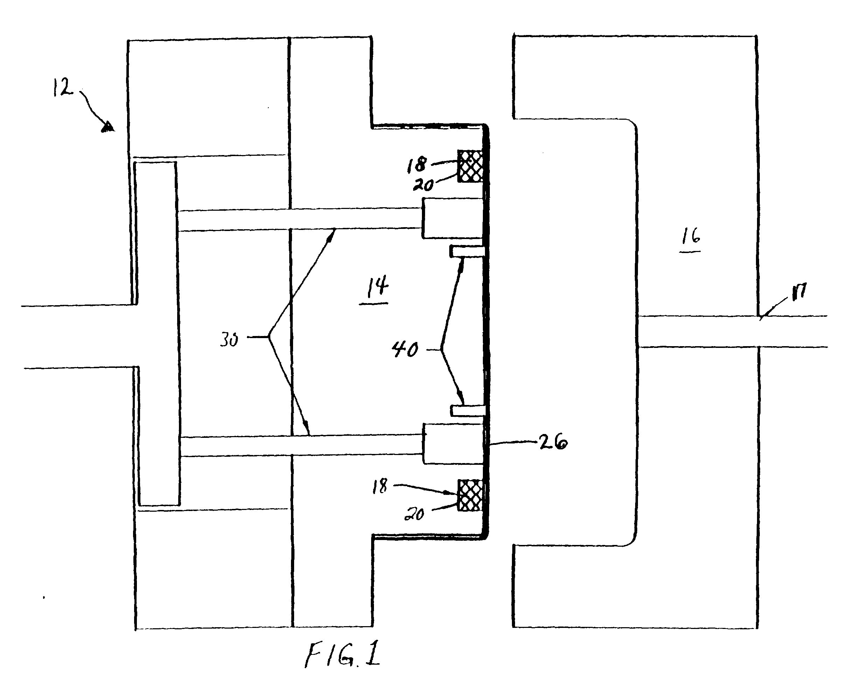

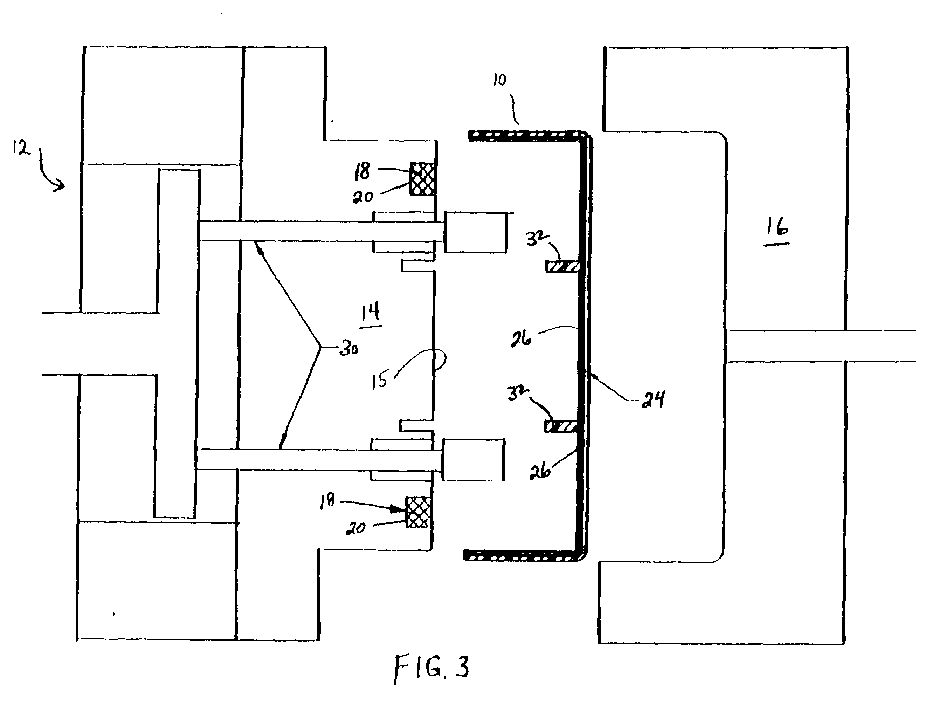

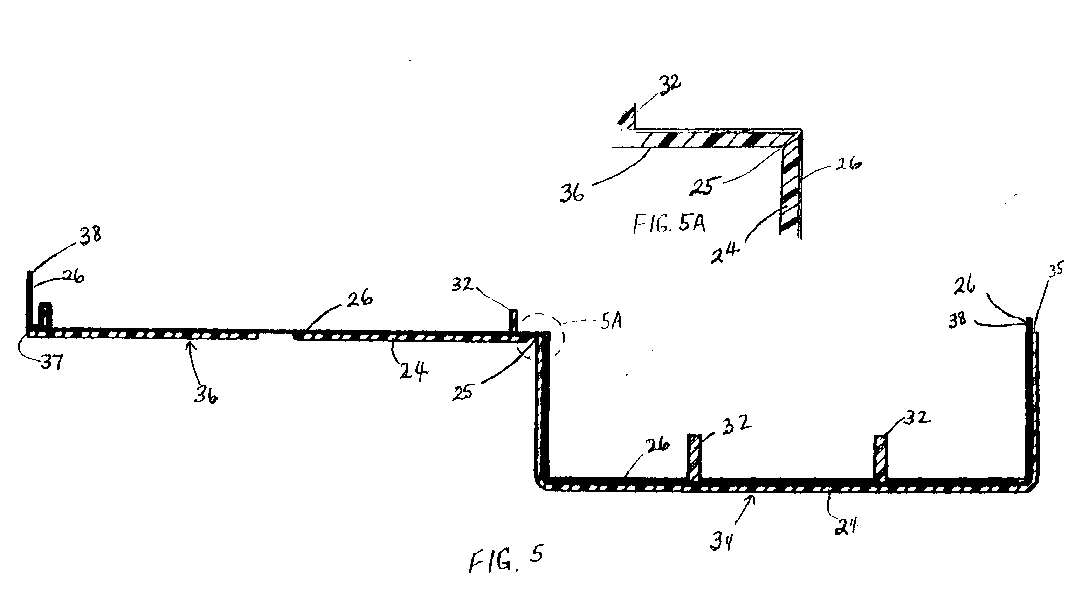

Referring now to the drawings wherein like numerals have been used throughout the several views to designate the same or, similar parts, the present invention is directed to molded electromagnetic shielding housings that provide enhanced shielding properties for shielding electronic waves from entering and emitting from an electronic device. As shown in FIGS. 1-4, the molded electromagnetic shielding structures and housings 10 (FIGS. 5-8 and 10) are made by utilizing an injection molding machine 12 which is comprised of a core portion 14 and a cavity portion 16. The core portion 14 includes a plurality of magnets or retaining means 18 associated with the core surface 15 (FIG. 3). The magnets 18 may be positioned within recesses 20 in the core surface 15 which provide for maintaining the grid material component properly positioned in the mold during molding of the electromagnetic shielding housing 10, as will be hereinafter described.

Although the preferred embodiment of the present invention contemplates the positioning of the grid material on the core surface 15 oft eh core portion, it is included within the present invention to utilize magnets in the cavity portion to retain the grid material on the cavity surface and to inject the plastic through the core portion to mold the shielding housing.

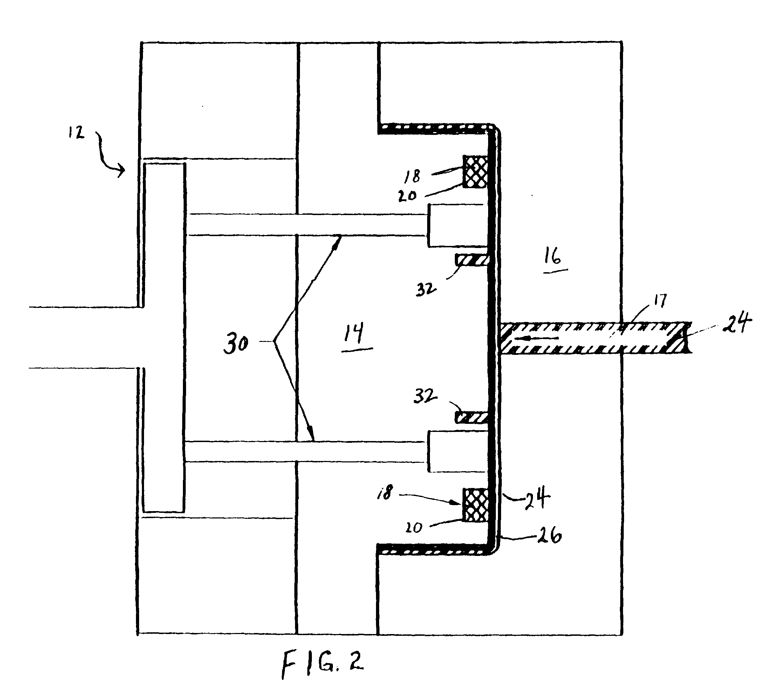

As shown in FIGS. 1-3, the core portion 14 includes lifters 30 movable within the core portion to facilitate removal of the molded electromagnetic shielding housing 10 after the molding operation or cycle has been completed. The cavity portion 16 of the molding machine 12 includes a sprue opening 17 which permits injection of the injectable plastic 24 (FIG. 2) into the molding machine 12.

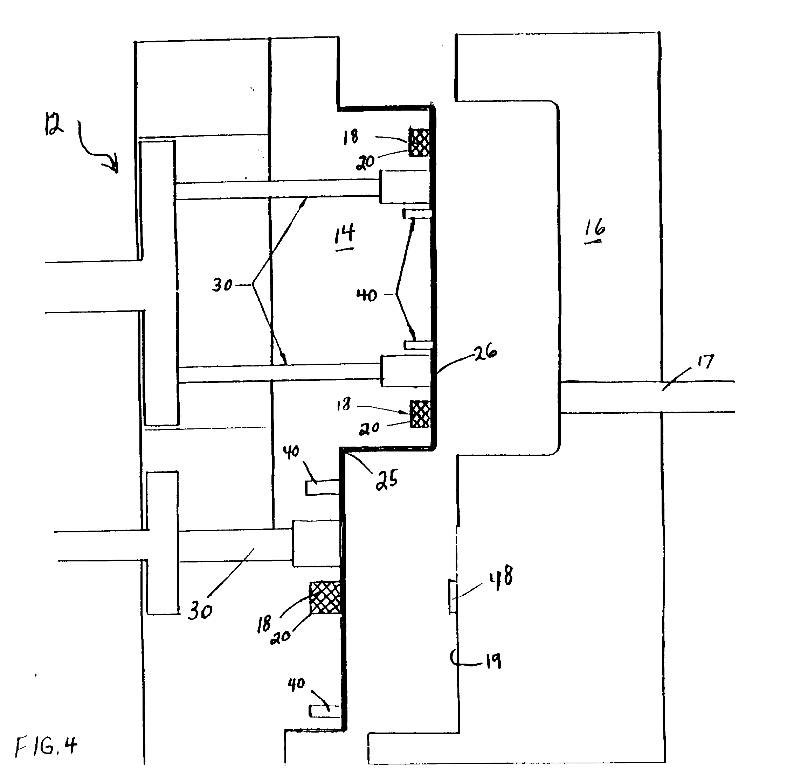

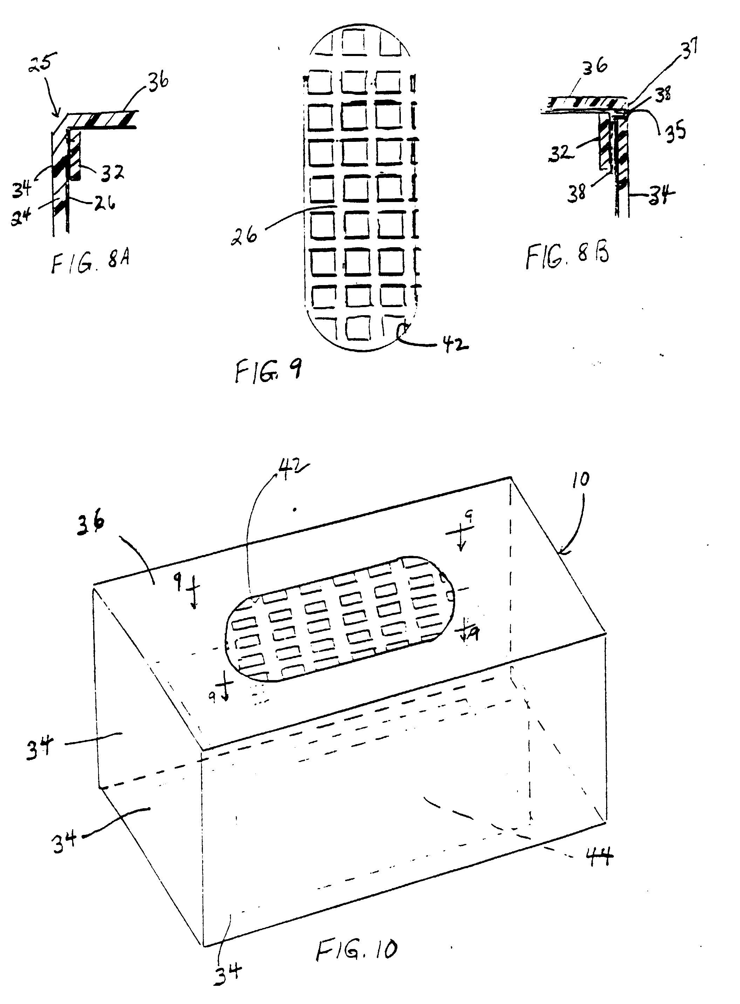

The method of molding the components of the electromagnetic shielding housing 10 is illustrated in reference to FIGS. 1-3 wherein a grid structure or substrate 26 is inserted into the mold to engage the core portion 14 of the molding machine 12 at the surface 15 thereof. The mesh-like grid material or substrate 26 useful in incorporation within an injection mold to provide an electromagnetic shielding housing which prevents electromagnetic waves from entering or exiting an enclosed electronic device, is a mesh-like nickel-coated filament material 26 which is compatible with injectable plastics. As shown in FIG 9, the mesh-like filament material has a grid-like configuration or structure. The nickel-coated filament grid material is available from National-Standard Company under the designation BOLTING cloth. It has been found that the nickel-coated substrate 26 does not oxidize when integrally molded to or positioned adjacent the surface of a molded housing. The nickel interstitices in the wire grid material or substrate 26 (FIG. 9) are bonded together to provide a structure which permits the grid material to exhibit substantial flexibility and strength. These properties facilitate the insertion and positioning of the substrate within a mold cavity of an injection molding machine 12, as shown in FIGS. 1 and 4). In FIG. 1, the grid substrate 26 is positioned within a mold cavity designed to produce a molded housing which is comprised of separate molded panel parts. In FIG. 4, the grid structure 26 is positioned within a mold cavity designed to produce a one-piece box-like molded shielding housing.

The injection molding operation first requires the predetermined placement and retention of a sheet of the conductive grid material or substrate 26 within the cavity of an injection molding machine 12. Because the grid material 26 is substantially flexible, the grid material may be inserted onto the surface 15 of the core portion 14 to conform to the configuration of the core surface 15. Magnets or other securing means, such as compatible adhesives, may be used to retain the grid material onto and about the surface core 15 of the core portion 14 of the molding machine 12 and to position the grid material 26 upon closure of the molding machine 12 for completion of the molding operation. The flexibility of the grid material 26 permits positioning about corners of the core surface 15 to provide the novel molded shielding housings of the present invention.

As shown in FIG. 2, the mold is closed by engaging the core portion 14 with the cavity portion 16 and injectable hot plastic 24 is injected into the mold through sprue opening 17 while the grid material or substrate 26 is, preferably, maintained on the inner surface of the resultant molded housing. After the molding operation is completed, the cavity and the core portions are disengaged and lifters 30 engage the finished molded shielding structure or housing 10 for removal from the mold for repeating the molding operation, as shown in FIG. 3. In FIGS. 1-4, the core portion 14 of the molding machine 12 includes recesses 40 therein which permit the resultant molded shielding housing to include re-enforcement ribs 32, as desired. It has been found that the positioning of the grid material 26 onto the interior surface of the mold substantially positions the conductive grid material on the inner surface of the finished molded housing 10. The molded panel or housing, containing conductive grid material is assembled to provide a box-like structure which provides excellent contact and conductivity for shielding electromagnetic waves from enclosed electronic devices. It also has been observed that the utilization of the grid substrate or material 26, when so positioned on the core surface of the mold, facilitates plastic flow into the mold, reduces the weakness of knit lines in the resultant molded shielding housing and reduces the impact of sink marks on the molded shielding housing. The molded shielding structure 10 when removed from the molded, as shown in FIG. 3, is intended as a part which may engage a similar molded part or panel to provide a final assembled box-like shielding housing. In such a assembly, the shielding structure 10 includes conductive grid material which extends beyond the edges 35 of the molded parts. When separate molded panels or parts are molded and each contain exposed ends of grid material extending beyond the molded edges, the exposed ends engage on another and provides excellent electrical contacts between the assembled panels. Thus, by properly sizing the molded parts used in assembling the box-like shielding housing and by wedging the exposed ends and sides of the panel into engagement with a complimentary molded housing part having exposed ends of grid material, a box-like shielding housing is provided. See FIG. 8B for a schematic view of the interlocking of the panel ends 35 together to complete the assembly. The completed box-like shielding housing is comprised of a molded conductive grid which completely envelopes the enclosed electronic device. Such a shielding housing prevents the entrance or exit of electromagnetic waves into or out of the enclosure.

In FIG. 4 an injection molding machine 12 is shown which permits the molding of a one-piece box-like electromagnetic shielding housing. Such a housing includes a foldable, integral top or cover portion 36 which may be hingedly positioned to engage and interlock with the base portion 34 to provide the one-piece box-like shielding housing 10. As shown in FIG. 4, the core portion 14 includes a plurality of magnets or retaining means 18 positioned in recesses 20 in the core surface 15. The retaining means retain and position the grid structure 26 to conform to the core surface. A plurality of lifters 30 are provided and moveable within the core portion 14 to facilitate the removal of the molded structure or housing after the molding cycle has been completed. The cavity portion 16 includes a sprue opening 17 which permits injection of the plastic 24 into the molding machine 12. As shown in FIG. 4, the electromagnetic shielding housing 10 is comprised of a base portion 34 and a cover or lid portion 36 molded integral thereto. The junction 25 between the base portion 34 and the lid portion 36 contains a uniform layer of flexible grid structure 26 extending continuously through this juncture on the inside surface of the molded layer of plastic material 24. Thus, the molded housing part contains a layer of grid material extending on or adjacent the inside surface of the base and lid portion. After the cavity portion 16 closes to engage the core portion 14 and plastic 24 is injected into the mold cavity, upon completion of the molding cycle, the mold is opened by disengaging the cavity from the core while lifters 30 disengage the resultant molded housing 10 from the conducting molding machine 12. The resultant one-piece molded housing 10 is comprised of a base and cover portions having an inner layer of grid material 26 integrally molded to the plastic material 24.

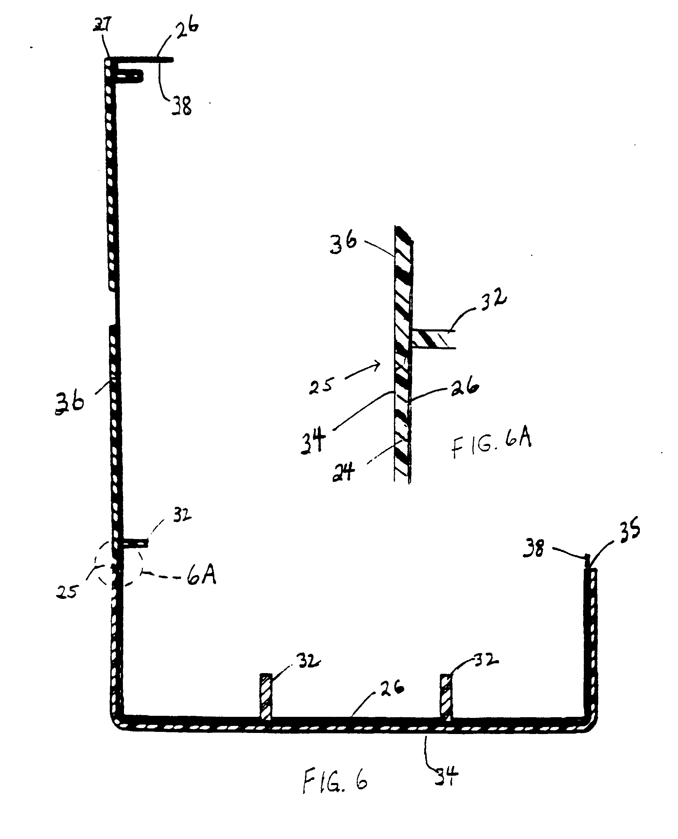

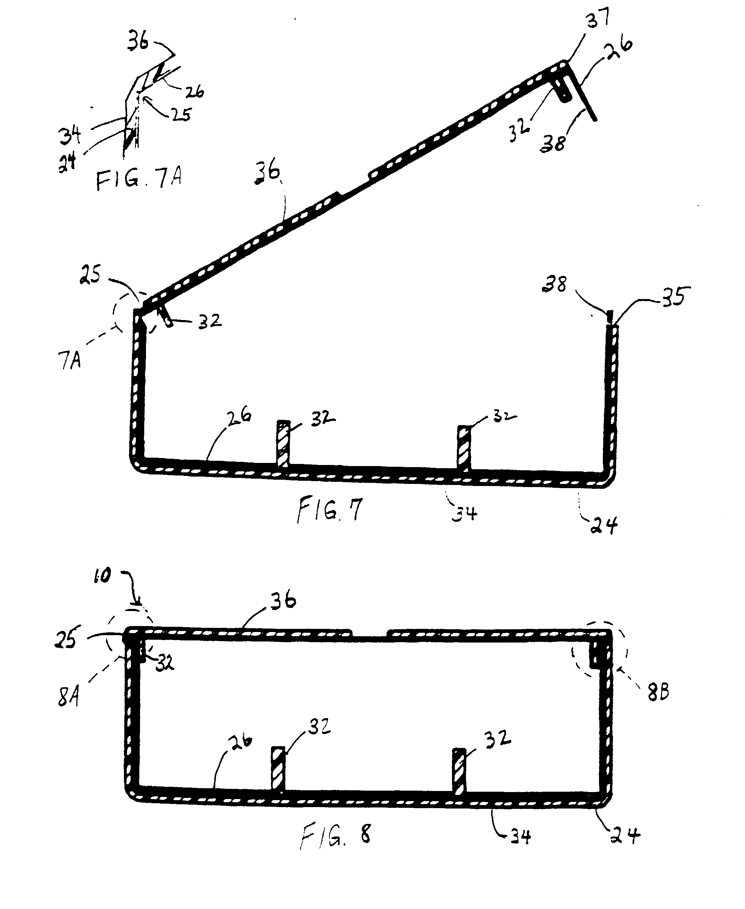

As shown in FIGS. 5 and 5A, the resultant molded electromagnetic shielding housing 10 includes a base portion 34 and a top or cover portion 36, integrally joined at a junction 25. When it is desired to complete and provide a box-like housing, the cover portion 36 is rotated about and onto the lower portion 34 by pivoting the top portion 36 about the junction 25. As shown in FIG. 6, the lid portion 36 has been rotated approximately 90 degrees from the initial horizonal position of the molding when the molding was removed from the molding machine 12. FIG. 6A is an enlarged view of junction 25 as shown in FIG. 6. As shown in FIGS. 7 and 7A, the cover portion 36 is further rotated to a position where the cover portion is ready to engage the upper edges 35 of the base portion 34. Finally, FIGS. 8 and 8B, illustrate the engagement of the edge portion 37 of the cover portion 36 to provide the sealing and interlocking engagement with the upper edge 35 of the base portion 34 to provide the completed box-like shielding housing 10.

The seal between the cover portion 36 and the base portion 34 is facilitated by the fact that the grid material 26 has been sized larger than the core surface of the mold. Thus, after molding, the grid material 26 extends outwardly from the edges 35 of the base portion 34 and of the edges 37 of the cover portion 36 to provide exposed end portions 38 extending from the shielding housing, as shown in FIGS. 5, 6 and 7. The exposed end portions 38 do not fray and provide an excellent conductive contact between the cover and base portions and provides sealing during wedging and joining of the cover portion 36 to the base portion 34. The interlocking of the seal between the parts of the molding compress the end portions into engagement with one another to provide a shielded enclosure or box-like housing which is adapted to receive and to enclose an electronic device and shield the same from electromagnetic radiation in accordance with the present invention.

The layer of grid substrate 26 which is molded integral with the surface of the molded housing provides several properties for the housing which provide uniform shielding of an electronic device. For example, the layer of grid substrate 26 extending through the junction 25, as shown in FIGS. 5 through 8A, provides a flexible hinge means or member which permits the ready assembly of box-like shielding housings from a one-piece molding. The exposed end portions 38 of the grid material extending from the one-piece molding permits the sealing engagement of the cover portion 36 with the base portion 34, as shown in FIGS. 8 and 8B. Specifically, as shown in FIG. 8B, the exposed end portion 38 of both the base portion and cover portion are wedged together to provide the box-like housing which is completely enclosed by the grid material/molded housing. The electrical contact between the exposed ends of the cover and base portions is achieved by wedging the ends into contact to complete the electrical contact therebetween. Also, the wedging action occurring during engagement of the molded parts or portions together results in a compression between the exposed ends of the grid material and panels to provide enhanced sealing and interlocking to provide a ridged box-like shielding housing 10.

In FIG. 4, the cavity portion 16 may include a post or projection member 48 extending from the interior surface thereof which is adapted to engage the grid material 26 upon closure of the molding machine 12. When the mold is in the closed position, the projection member 48 prevents the flow of plastic material 24 onto the grid material which is covered, engaged, and protected by the projection member 48. The projection member or members are designed to provide predetermining openings in the molded box-like shielding housing which permits ventilation and air flow into the housing and permits cooling of the enclosed electronic device, as desired. As shown in the partial top plan view of FIG. 9, the grid material 26 extends across the opening or ventilation opening 42 defined by the projection member 48.

Finally, FIG. 10 is a perspective view illustrating the box-like electromagnetic shielding housing 10 which may be constructed from a one piece molding. When the cover portion 36 is rotated from the horizonal 180 degrees to seal against the edges of the base portion, the enclosed one-piece unitary box-like shielding housing is provided. This shielded housing may enclose radios, CD players, electronic control units, air bag control modules, integral electronic control units and industrial control modules. Also, automotive motors such as windshield wiper motors, window regulator motors and seat adjustment motors and electronic devices, such as computers, printers, cable boxes, drive cases, computer screen monitors and cellular phone assemblies are depicted by dotted line 44 within the enclosed box-like shielded housing 10.

As described in the present invention, the preferred embodiment is illustrated in the drawings. Modifications and alterations may become apparent to the person skilled in the art after reading and understanding the specification and it is intended that the specification and drawings include modifications and alterations within the scope of the appended claims.

## Claims

1. Apparatus for molding an electromagnetic shielding housing, the apparatus comprising:
a core portion (14);
a cavity portion (16), the core portion (14) and cavity portion (16) being moveable with respect to each other between an open position and a closed position for molding;
an injection opening (17) in at least one of said core portion (14) or said cavity portion (16); and
positioning means associated with at least one of said core portion (14) or said cavity portion (16), the positioning means being adapted, in operation, to retain a conductive flexible metal grid material (26) on at least one surface (15) of the core portion (14), whereby, by injecting a moldable plastics material (24) through said injection opening (17) and subsequently hardening said plastics material, a completed molded shielding housing member may be produced, having said conductive metal grid material integrally positioned on at least one inside surface thereof.

2. Apparatus according to claim 1, wherein the positioning means is an adhesive.

3. Apparatus according to claim 1, wherein the positioning means is a magnet (18).

4. Apparatus according to any of claims 1 to 3, wherein the core portion (14) and the cavity portion (16) define between them the profile of a base member portion (34) having corners thereon.

5. Apparatus according to claim 4, wherein the core portion (14) and the cavity portion (16) further define between them the profile of a box-like shielding housing structure (10) having an integrally hinged top portion (36) engageable with said base member portion (34) to complete the electromagnetic shielding housing.

6. A method of molding an electromagnetic shielding housing in an injection molding machine (12) having a core portion (14) and a cavity portion (16), comprising the steps of:
positioning and retaining a conductive flexible metal grid material (26) on at least one surface (15) of either the core or the cavity portion;
closing the core portion (14) and the cavity portion (16) together to confine the flexible metal grid material (26) therebetween;
directing injectable plastics material (24) into the space between the core portion (14) and the cavity portion (16); and
opening the injection molding machine (12) to remove the molded electromagnetic shielding housing (10) having at least one surface thereof comprised of a conductive grid material molded integrally with the injectable plastics material.

7. A method according to claim 6, wherein the space between the core portion (14) and the cavity portion (16) defines the profile of a molded base portion (34) and an integrally hinged cover portion (36), which may be assembled into a one-piece box-like shielding housing upon removal from the mold machine.

8. A method according to claim 6 or claim 7, wherein at least one of said core and said cavity portions includes a projection (48) thereon which engages said grid material (26) when the mold machine is in the closed position to provide a molded housing surface having a predetermined opening therein covered by said grid material.

9. A method according to any of claims 6 to 8, wherein during the step of positioning the conductive grid material (26), the grid material extends beyond the edge of at least one surface provided by at least one of said core or cavity portions (14 & 16), such that upon opening of the injection molding machine (12), the conductive grid material extends outwardly from the molding (10).
